(19) Europäisches Patentamt

European Patent Office

Office européen des brevets

(11) **EP 0 551 222 B1**

(12) **FASCICULE DE BREVET EUROPEEN**

(45) Date de publication et mention
de la délivrance du brevet:
**10.04.1996 Bulletin 1996/15**

(51) Int Cl.⁶: **G01D 11/28**, G01D 13/22,
B60Q 3/04, G12B 11/04,
G01R 1/08

(21) Numéro de dépôt: **93400008.4**

(22) Date de dépôt: **05.01.1993**

(54) **Dispositif indicateur à aiguille éclairante**

Anzeigevorrichtung mit beleuchtetem Zeiger

Indicating instrument having an illuminated pointer

(84) Etats contractants désignés:
**DE ES GB IT**

(30) Priorité: **06.01.1992 FR 9200034**

(43) Date de publication de la demande:
**14.07.1993 Bulletin 1993/28**

(73) Titulaire: **JAEGER**
**F-92000 Nanterre Cédex (FR)**

(72) Inventeur: **Wroblewski, Jérôme**
**F-93800 Epinay-sur-Seine (FR)**

(74) Mandataire: **Schrimpf, Robert et al**
**Cabinet Regimbeau**
**26, Avenue Kléber**
**F-75116 Paris (FR)**

(56) Documents cités:
**EP-A- 0 078 372**          **GB-A- 2 185 576**

## Description

La présente invention concerne le domaine des dispositifs indicateurs à aiguille éclairante.

La présente invention s'applique tout particulièrement, mais non exclusivement, à la conception de tableaux de bord de véhicules automobiles.

L'utilisation d'aiguilles éclairantes a pour fonction essentielle de faciliter l'observation des appareils indicateurs la nuit, ou d'une façon plus générale lorsque la lumière ambiante est déficiente.

Les aiguilles indicatrices sont généralement formées d'un moyeu destiné à être chassé sur un arbre de commande rotatif, lequel moyeu supporte un corps d'aiguille allongé s'étendant de part et d'autre du moyeu, pour des raisons d'esthétique et d'équilibre. L'arbre de commande est le plus souvent issu d'un appareil indicateur à commande électrique dénommé "mouvement de mesure" par les spécialistes, par exemple un logomètre. En variante l'arbre de commande sur lequel est chassée l'aiguille peut être lié à cet appareil indicateur, par l'intermédiaire d'un train d'engrenages.

On connaît deux types principaux d'aiguilles indicatrices.

Les aiguilles du premier type peuvent être réalisées en un matériau opaque sur le plan optique. Elles sont pourvues, sur leur surface avant visible, d'un revêtement coloré et sont associées à des sources lumineuses placées sur l'avant pour éclairer le revêtement en cas d'éclairage ambiant insuffisant. Ces aiguilles ont déjà rendu de grands services. Cependant, elles apparaissent peu lumineuses par comparaison avec les aiguilles dites éclairantes. De ce fait, elles ne donnent pas entière satisfaction quant à l'esthétique, l'agrément et la fiabilité de l'observation.

Les aiguilles du second type dites éclairantes sont formées pour l'essentiel d'un matériau transparent sur le plan optique et sont associées à des sources lumineuses placées latéralement ou sur l'arrière de l'aiguille pour injecter la lumière dans le corps de l'aiguille qui sert de guide de lumière. Les aiguilles dites éclairantes sont préférées de nos jours aux aiguilles du premier type précité.

Dans la suite de la description, on appellera "face avant" de l'aiguille, la face de celle-ci dirigée vers l'observateur et "face arrière" de l'aiguille, la face de celle-ci située du côté opposé à l'observateur.

On a ainsi proposé, comme décrit notamment dans les documents FR-A-2615992, DE-A-3435377 et DE-A-3425029, des dispositifs indicateurs comprenant :

- un appareil indicateur
- un arbre de commande rotatif entraîné par l'appareil indicateur de sorte que sa position angulaire par rapport à une position d'origine dépend d'un paramètre d'entrée à visualiser,
- une aiguille éclairante liée à l'arbre de commande pour être entraînée à pivotement par celui-ci,
- plusieurs sources lumineuses, et

- un guide optique, optiquement transparent, placé en regard des sources lumineuses et sur l'arrière de l'aiguille, généralement entre l'aiguille et l'appareil indicateur, pour récupérer la lumière émise par les sources lumineuses et diriger celle-ci vers l'aiguille.

Par ailleurs, on a proposé, comme décrit par exemple dans les documents FR-A-2418503, FR-A-2422147, DE-A-2838261 et DE-A-2848001 des dispositifs indicateurs comprenant :

- un appareil indicateur,
- un arbre de commande rotatif entraîné par l'appareil indicateur de sorte que sa position angulaire par rapport à une position d'origine dépende d'un paramètre d'entrée à visualiser,
- une aiguille éclairante liée à l'arbre de commande pour être entraînée à pivotement de celui-ci,
- une source lumineuse, et
- un guide optique, optiquement transparent, placé en regard de la source lumineuse et sur l'arrière de l'aiguille, lequel guide optique possède
- une structure réfléchissante formée d'une facette oblique centrée sur l'axe de l'arbre de commande et de l'aiguille, de sorte que le guide optique récupère la lumière émise par la source lumineuse et dirige une partie de celle-ci vers l'aiguille grâce à la structure réfléchissante.

Le document EP-A-78732 décrit un dispositif indicateur conforme au préambule de la revendication 1, comprenant :

- un appareil indicateur,
- un arbre de commande rotatif entraîné par l'appareil indicateur,
- une aiguille éclairante liée à l'arbre de commande,
- une source lumineuse, et
- un guide optique optiquement transparent placé en regard de la source lumineuse, lequel guide optique possède
- une structure réfléchissante généralement centrée sur l'axe de l'arbre de commande et de l'aiguille pour renvoyer vers l'aiguille une partie de la lumière provenant de la source lumineuse, et
- au moins une structure conçue pour renvoyer vers la structure réfléchissante généralement centrée sur l'axe de l'arbre de commande la lumière qu'elle reçoit en provenance de la source lumineuse.

Les dispositifs indicateurs décrits dans ces derniers documents offrent l'avantage de n'exiger qu'une seule source lumineuse et d'éclairer l'aiguille sur un angle important autour de son axe, donc d'autoriser un pivotement important de l'aiguille.

D'une part, la plage couverte par la structure réfléchissante autour de l'axe de l'aiguille est de surface limitée.

D'autre part, les structures réfléchissantes jusqu'ici proposées, formées d'une facette unique ne génèrent pas un éclairage homogène de l'aiguille sur 360°. En particulier, l'arbre de commande et le moyeu de l'aiguille forment une zone d'ombre non éclairée à l'opposé de la source lumineuse.

La présente invention a pour but de perfectionner les dispositifs indicateurs existants à aiguille éclairante.

Ce but est atteint selon la présente invention grâce à un dispositif indicateur de type connu comprenant :

- un appareil indicateur
- un arbre de commande rotatif entraîné par l'appareil indicateur,
- une aiguille éclairante liée à l'arbre de commande,
- une source lumineuse et
- un guide optique, optiquement transparent, placé en regard de la source lumineuse, lequel guide optique possède
- une structure réfléchissante généralement centrée sur l'axe de l'arbre de commande et de l'aiguille pour renvoyer vers l'aiguille une partie de la lumière provenant de la source lumineuse, et au moins une structure conçue pour renvoyer vers la structure réfléchissante généralement centrée sur l'axe de l'arbre de commande la lumière qu'elle reçoit en provenance de la source lumineuse caractérisé selon la présente invention,
- par le fait que la structure de renvoi prévue sur le guide optique comprend au moins une structure de prisme en toit, le guide optique est placé sur l'arrière de l'aiguille et
- par le fait que ladite structure réfléchissante généralement centrée sur l'axe de l'arbre de commande comprend différentes facettes réfléchissantes réparties autour de l'axe de l'arbre de commande et ayant des lignes de plus grande pente non parallèles.

De préférence, le guide optique comprend plus précisément deux prismes en toit symétriques non colinéaires.

Selon une autre caractéristique avantageuse de la présente invention, chaque prisme en toit est adapté pour renvoyer sous forme d'un faisceau parallèle le faisceau lumineux divergent reçu de la source lumineuse.

Selon une caractéristique avantageuse, l'arête supérieure de chaque prisme en toit à la forme d'un cercle.

Selon une autre caractéristique avantageuse de la présente invention, la structure réfléchissante du guide optique généralement centrée sur l'axe de l'arbre de commande, comprend des facettes conçues pour dévier d'environ 90° le faisceau reçu du prisme en toit afin de renvoyer ce faisceau vers l'aiguille.

Selon une autre caractéristique avantageuse de la présente invention, la structure réfléchissante du guide optique généralement centrée sur l'axe de commande, comprend des facettes conçues pour dévier d'environ 90° le faisceau reçu directement de la source lumineuse, pour renvoyer ce faisceau vers l'aiguille.

Selon une autre caractéristique avantageuse de la présente invention, la structure réfléchissante du guide optique généralement centrée sur l'axe de l'arbre de commande, comprend deux paires de facettes conçues pour dévier de 90° le faisceau reçu des prismes en toit et trois facettes conçues pour dévier de 90° le faisceau reçu directement de la source lumineuse.

D'autres caractéristiques, buts et avantages de la présente invention apparaîtront à la lecture de la description détaillée qui va suivre et en regard des dessins annexés donnés à titre d'exemples non limitatifs et sur lesquels :

- la figure 1 représente une première vue en plan d'un guide optique conforme à la présente invention,
- la figure 2 représente une vue en plan de la face opposée du même guide optique,
- la figure 3 représente une vue en coupe transversale du même guide optique selon le plan de coupe référencé III-III sur la figure 2,
- la figure 4 représente une seconde vue en coupe transversale du guide optique selon le plan de coupe référencé IV-IV sur la figure 2,
- la figure 5 représente une vue en coupe oblique du guide optique, selon le plan de coupe référencé V-V sur la figure 2,
- la figure 6 représente une vue en coupe longitudinale du même guide optique selon le plan de coupe référencé VI-VI sur la figure 2,
- la figure 7 représente une vue en perspective schématique d'une source lumineuse préférentielle utilisée dans le cadre de la présente invention,
- la figure 8 représente une première vue latérale de la même source lumineuse,
- la figure 9 représente une seconde vue latérale de la même source lumineuse,
- la figure 10 représente une vue en bout de la même source lumineuse,
- la figure 11 représente une vue schématique en perspective d'un dispositif indicateur conforme à la présente invention comprenant une variante de guide optique,
- la figure 12 représente une vue latérale du dispositif indicateur conforme à la même variante,
- les figures 13 et 14 représentent schématiquement le faisceau lumineux issu de la source lumineuse conforme aux figures 7 à 10, dans deux plans de symétrie orthogonaux entre eux,
- les figures 15 et 16 représentent plus précisément la distribution spatiale de l'intensité lumineuse mesurée dans deux plans de symétrie orthogonaux entre eux sur la source lumineuse conforme aux figures 7 à 10,
- la figure 17 illustre schématiquement la fonction du prisme en toit utilisé dans le cadre du mode de réalisation représenté sur les figures 1 à 6,

- la figure 18 représente une vue en coupe longitudinale d'une facette de renvoi utilisée dans le cadre d'une variante de réalisation de la présente invention,
- la figure 19 représente une vue en plan d'une autre variante de réalisation d'un guide optique conforme à la présente invention,
- la figure 20 représente une vue en coupe de ce guide optique selon le plan de coupe référencé XX-XX sur la figure 19,
- la figure 21 représente selon une vue en coupe longitudinale une facette conforme à une variante de réalisation de la présente invention, et
- la figure 22 représente selon une vue en plan une variante de réalisation du guide optique et illustre plus particulièrement le rôle de la face d'entrée.

PREMIER MODE DE REALISATION

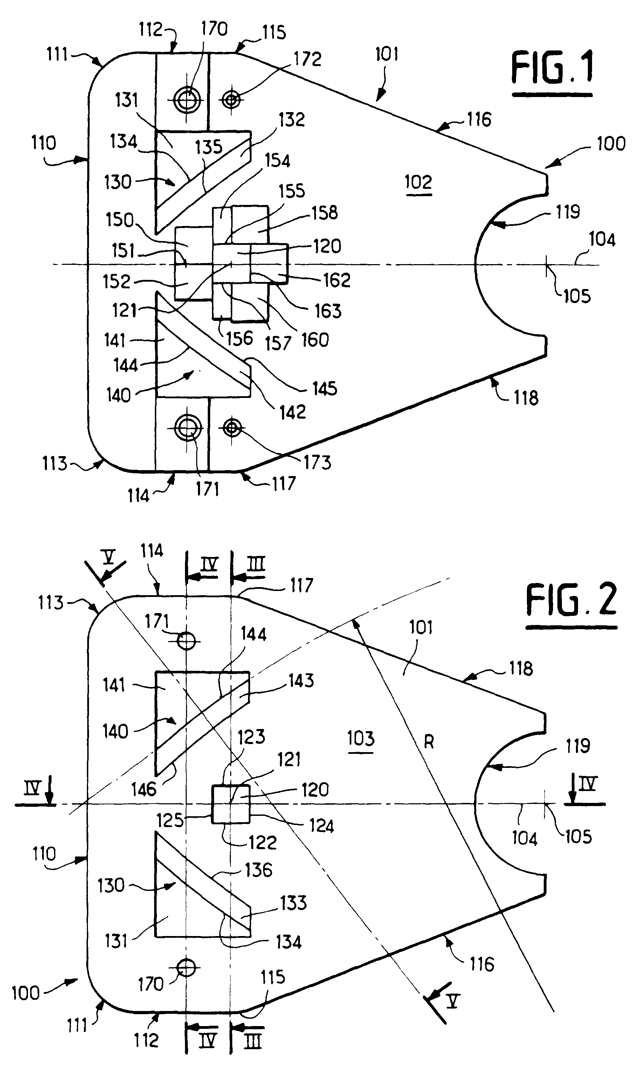

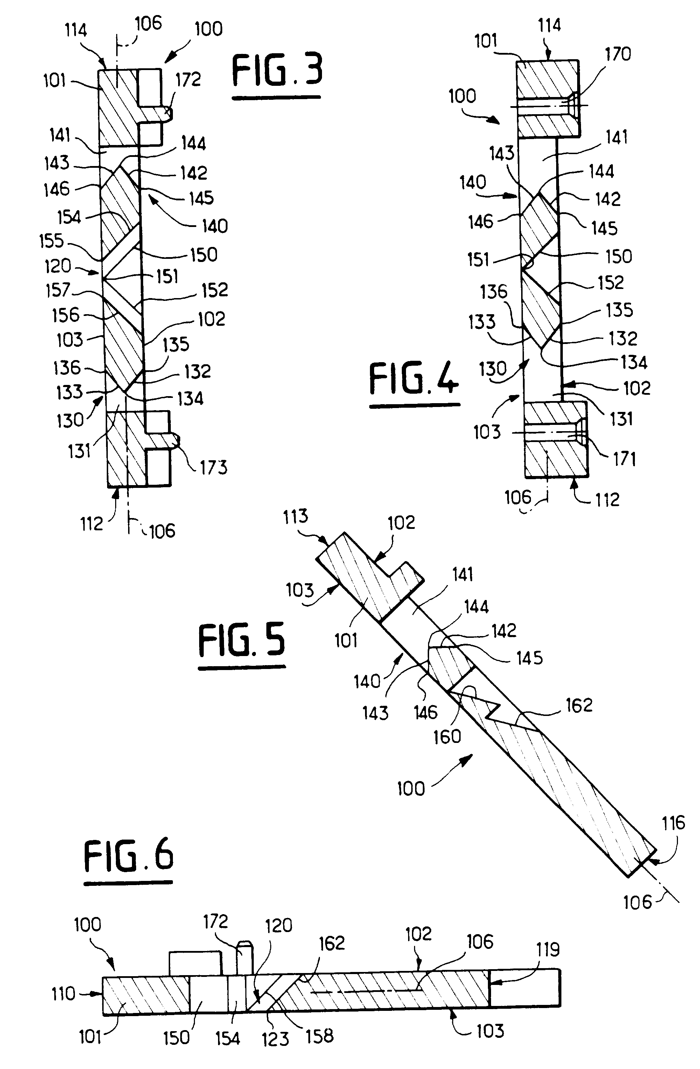

On va tout d'abord décrire le premier mode de réalisation du guide optique conforme à la présente invention en regard des figures 1 à 6.

Le guide 100 comprend une plaquette plane 101 en matériau optiquement transparent.

La plaquette 101 possède deux faces principales planes et 102, 103. Selon les figures 1 à 6 ces deux faces principales 102, 103 sont parallèles. Comme on le verra par la suite, les deux faces principales 102, 103 peuvent cependant être localement obliques entre elles.

La plaquette 101 possède un plan de symétrie longitudinal 104 qui coïncide avec le plan de coupe VI-VI. Ce plan de symétrie 104 est perpendiculaire au plan des figures 1 et 2.

Sur les figures 1 et 2, on a référencé 105 l'image de la source lumineuse associée au guide optique 100 vue à travers son optique. Toutefois, la source lumineuse 105 n'a pas été représentée sur ces figures pour simplifier l'illustration.

Le guide 100 a un contour général triangulaire.

Ce contour est délimité essentiellement par une face latérale de base 110, deux faces latérales auxiliaires 112, 114, deux faces latérales principales 116, 118, et une face d'entrée 119.

Ces diverses faces 110, 112, 114, 116, 118, 119, sont perpendiculaires aux faces principales 102, 103.

La face latérale de base 110 est plane et perpendiculaire au plan de symétrie 104.

Les faces latérales auxiliaires 112, 114 sont planes, parallèles entre elles et parallèles au plan de symétrie 104, soit orthogonales à la face latérale de base 110.

Les faces latérales auxiliaires 112, 114, sont reliées à la face latérale de base 110 par des secteurs cylindriques convexes vers l'extérieur 111, 113, centrés sur des axes perpendiculaires aux faces principales 102, 103.

Les faces latérales principales 116, 118, sont planes et symétriques par rapport au plan 104.

Elles se raccordent respectivement aux faces latérales auxiliaires 112, 114, au niveau d'arêtes 115, 117, qui s'étendent perpendiculairement aux faces principales 102, 103. Les faces latérales principales 116, 118, convergent en éloignement des faces auxiliaires 112, 114.

La face d'entrée 119 est située entre les faces latérales principales 116, 118. La face d'entrée 119 est formée d'un secteur hémicylindrique centré sur un axe contenu dans le plan de symétrie 104, perpendiculaire aux faces principales 102, 103 et passant par le point image 105 précité.

Comme indiqué précédemment, le guide optique 110 conforme à la présente invention comprend diverses structures à effet de prisme réfléchissant.

Plus précisément, selon le mode de réalisation représenté sur les figures 1 et 2, le guide optique 110 comprend deux prismes en toit 130, 140, et plusieurs facettes de renvoi, réparties autour de l'axe 121 de l'arbre de commande.

Plus précisément encore, selon ce mode de réalisation représenté sur les figures 1 et 2, le guide optique 110 comprend trois paires de facettes de renvoi symétrique deux à deux par rapport au plan 104: 150, 152 ; 154, 156 et 158, 160, plus une facette 162 centrée sur le plan 104.

Ces diverses facettes de renvoi 150, 152, 154, 156, 158, 160 et 162 entourent un orifice 120. Cet orifice 120 traverse la plaque 110 selon son épaisseur et sert au passage de l'arbre de commande issu de l'appareil indicateur. L'orifice 120 est pour cela centré sur l'axe 121 de l'arbre de commande. Cet axe 121 coïncide avec l'intersection des plans de coupe III-III et VI-VI. L'orifice 120 est de préférence entouré par les facettes de renvoi précitées. Pour cela, il présente une section carrée. L'orifice 120 est ainsi délimité par quatre arêtes rectilignes 122, 123, 124, 125 au niveau de la face principale 103. Les arêtes 122, 123 sont parallèles entre elles et parallèles au plan de symétrie 104.

Les deux arêtes 124, 125, sont parallèles entre elles et orthogonales au plan de symétrie 104.

Les prismes en toit 130, 140, sont formés sur un flanc de découpes respectives 131, 141, formées dans la plaquette 101 et traversant celle-ci selon son épaisseur.

Les prismes en toit 130, 140, sont ainsi formés par le flanc latéral des découpes 131, 141, le plus proche de l'axe 121.

Chaque prisme en toit 130, 140 est formé essentiellement de deux faces 132, 133 ; 142, 143, symétriques par rapport à un plan 106, parallèle aux faces principales 102, 103 et équi-distant de celles-ci. Les faces 132, 133 ; 142, 143, des prismes en toit 130, 140, sont formées par des génératrices rectilignes inclinées de préférence de 45° par rapport aux faces principales 102, 103. Les faces de renvoi 132, 133 d'une part, 142, 143 d'autre part sont ainsi orthogonales entre elles.

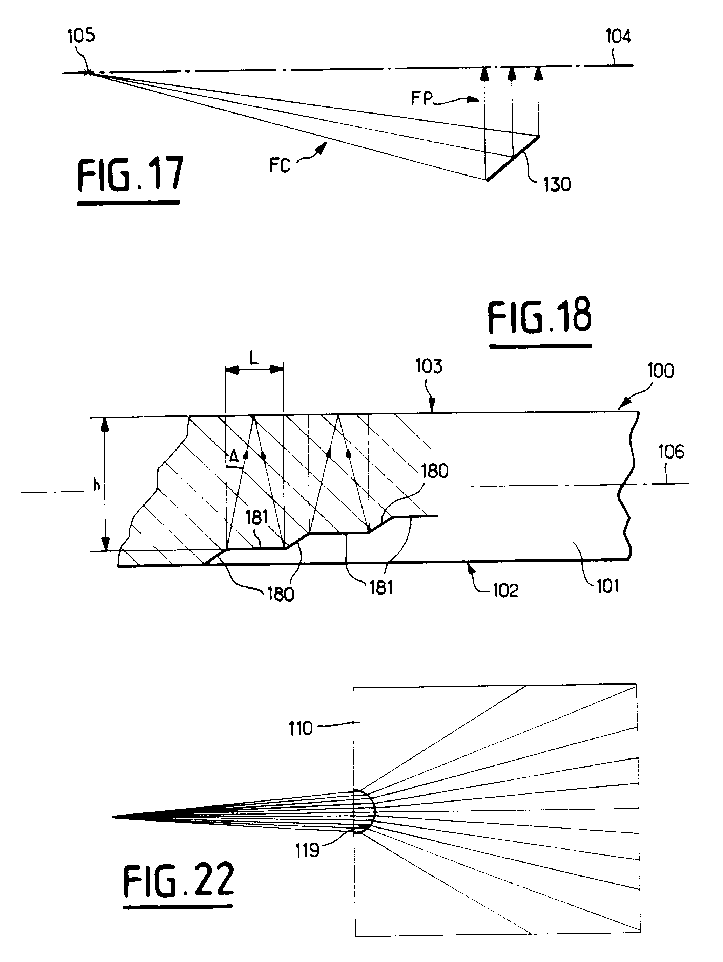

Comme cela est schématisé sur la figure 17, chaque prisme en toit 130, 140, est conçu de telle sorte qu'il transforme un faisceau FC conique dans tout plan parallèle au plan 106, issu du point image 105 en un faisceau FP parallèle dans tout plan parallèle au plan 106, dont la direction est parallèle à la ligne de plus grande pente des facettes de renvoi 150, 152, et 154, 156. Plus précisément, les prismes en toit 130, 140, sont adaptés pour transformer le faisceau conique FC issu du point image 105 en un faisceau parallèle FP dont la direction s'étend de préférence perpendiculairement au plan de symétrie 104.

Plus précisément, selon le mode de réalisation représenté sur les figures, les génératrices précitées délimitant les surfaces de renvoi 132, 133 ; 142, 143, s'appuient sur des secteurs de cercle. Ainsi, l'arête supérieure 134, 144, de chaque prisme en toit 130, 140, formée par l'intersection des faces 132, 133, d'une part, 142, 143, d'autre part, a la forme d'un secteur de cercle. Il en est de même pour les arêtes de base 135, 136 ; 145, 146, des faces de renvoi 132, 133 et 142, 143, respectivement sur les faces principales 102, 103.

En variante, l'arête supérieure 134, 144 de chaque prisme en toit 130, 140 peut être formée de toute conique appropriée, ou le cas échéant une courbe asphérique permettant la transformation d'un faisceau conique en faisceau parallèle.

La fonction des facettes de renvoi 150, 152, 154, 156, est de renvoyer vers l'aiguille, soit de préférence perpendiculairement aux faces principales 102, 103 parallèlement à l'axe 121, et vers la face principale 103, la lumière issue du prisme en toit 130, 140.

La fonction des facettes de renvoi 158, 160, 162, est de renvoyer vers l'aiguille, soit de préférence perpendiculairement aux faces principales 102, 103, parallèlement à l'axe 121, vers la face principale 103, la lumière issue directement de la source lumineuse 105.

On verra par la suite que la lumière renvoyée par les facettes 150, 152, 154, 156, 158, 160, 162 peut être oblique sur les faces principales 102, 103 et non perpendiculaire à celles-ci.

Les facettes de renvoi 150, 152 sont planes. Elles sont symétriques par rapport au plan 104.

Leur ligne de plus grande pente est située dans un plan perpendiculaire au plan de symétrie 104 et perpendiculaire également au plan 106 précité. De préférence, les facettes de renvoi 150, 152, sont inclinées de 45° sur chacun des plans 104, 106 précités.

Les facettes de renvoi 150, 152, convergent vers le plan de symétrie 104 en éloignement de la face principale 102.

Les facettes de renvoi 150, 152 forment ainsi un dièdre concave vers la face principale 102. L'arête 151 commune aux deux facettes de renvoi 150, 152 est contenue dans le plan de symétrie 104 et située sensiblement au niveau de la face principale 103.

Les facettes de renvoi 150, 152, sont adjacentes à l'orifice 120. Elles sont situées à l'opposé de l'image 105 par rapport à cet orifice 120.

Les facettes de renvoi 154, 156, sont situées respectivement entre les facettes de renvoi 150, 152, précitées et le point image 105.

Les facettes de renvoi 154, 156, sont planes. Leur ligne de plus grande pente est située dans un plan orthogonal au plan de symétrie 104 et au plan 106 précité. De préférence, les facettes de renvoi 154, 156, sont inclinées de 45° par rapport aux faces principales 102, 103. Les facettes de renvoi 154, 156, convergent vers le plan de symétrie 104 en éloignement de la face principale 102. L'arête supérieure 155, 157 des facettes de renvoi 154, 156, est située sensiblement sur la face principale 103. Cette arête supérieure 155, 157, correspond à la moitié des arêtes 122, 123, de l'orifice 120.

Les facettes de renvoi 158, 160, sont situées respectivement entre les facettes de renvoi 154, 156 précitées et le point source 105.

Les facettes de renvoi 158, 160 sont planes. Leur ligne de plus grande pente est située dans un plan parallèle au plan de symétrie 104. Les facettes de renvoi 158, 160, sont de préférence situées à 45° des faces principales 102, 103. Elles convergent vers la face principale 103 en éloignement du point image 105.

Les facettes de renvoi 158, 160, sont adjacentes à l'orifice 120, plus précisément aux arêtes 122, 123 de celui-ci.

La facette de renvoi 162 est située entre les facettes de renvoi 158, 160 précitées d'une part, et entre l'orifice 120 et le point image 105 d'autre part.

La facette de renvoi 162 est plane. Elle est inclinée d'environ 45° sur les faces principales 102, 103. La ligne de plus grande pente de la facette de renvoi 162 est située dans le plan 104 et cette facette 162 converge vers la face principale 103 en éloignement du point image 105.

L'arête supérieure 163 de la facette de renvoi 162 est située, de préférence, dans la face principale 103. Cette arête supérieure 163 de la facette de renvoi 162 coïncide avec l'arête 124 de l'orifice 120.

La plaquette 101 possède des moyens de fixation sur les éléments associés du dispositif indicateur, par exemple sur l'appareil indicateur lui-même. Ces moyens de fixation peuvent faire l'objet de nombreuses variantes de réalisation.

Pour ces raisons, ces moyens de fixation ne seront pas décrits dans le détail par la suite.

On notera cependant que de tels moyens de fixation peuvent comprendre des orifices 170, 171, traversant l'épaisseur de la plaquette 101 et des pattes 172, 173, en saillie sur l'une des faces principales, par exemple sur la face principale 102.

Bien entendu, ces moyens de fixation formés d'orifices traversants et de pattes en saillie, doivent être prévus sur l'extérieur des structures à effet de prisme afin de ne pas perturber le cheminement des rayons lumineux.

SOURCE LUMINEUSE 200

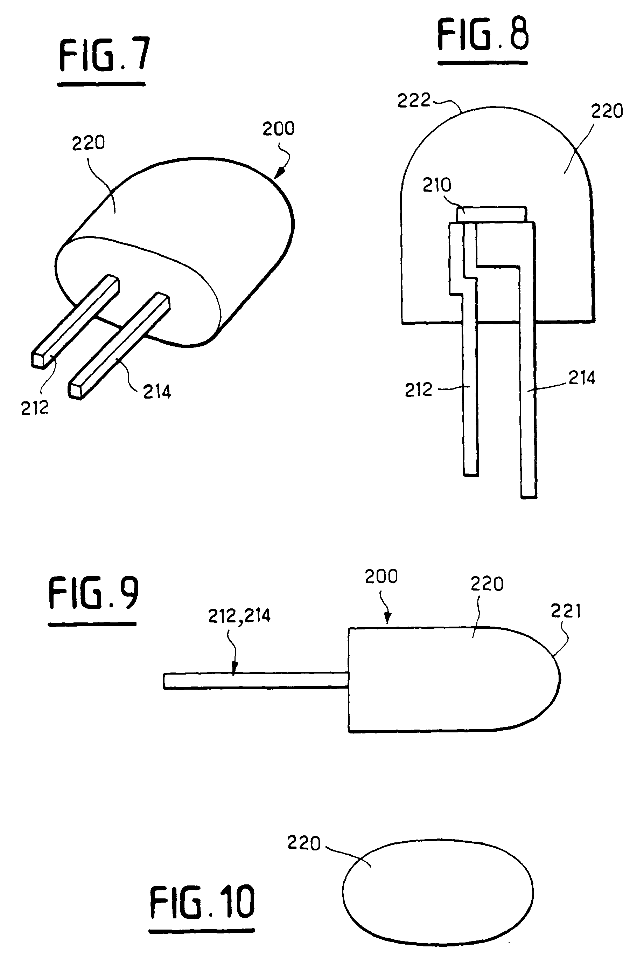

On va maintenant décrire un mode de réalisation avantageux d'une source lumineuse 200 conforme à la présente invention en regard des figures 7 à 10.

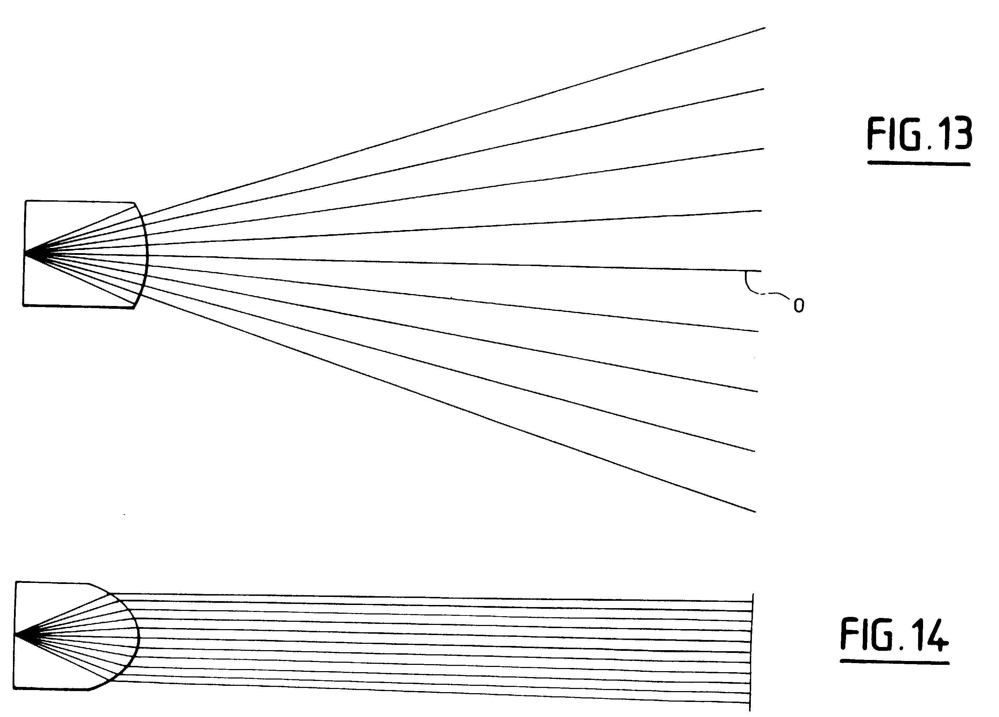

Cette source lumineuse 200 est conçue pour générer un faisceau parallèle dans le plan de symétrie 104 comme représenté sur la figure 14 et divergent dans le plan médian 106 de la plaquette 101 comme représenté sur la figure 13.

Plus précisément, la source lumineuse 200 est adaptée pour générer dans le plan de symétrie 104, comme représenté sur la figure 14, un faisceau parallèle d'une largeur au moins égale et de préférence sensiblement égale à l'épaisseur du guide 100. La source lumineuse 200 est ainsi adaptée de préférence pour générer dans le plan 104 un faisceau parallèle d'une largeur de l'ordre de 4mm.

Par ailleurs, dans le plan médian 106 de la plaquette 101, la source lumineuse 200 est de préférence adaptée pour générer un faisceau divergent de plus ou moins 20°.

A l'utilisation, l'image de la source lumineuse vue à travers son dioptre optique est centrée sur le point image 105, l'axe optique central O-O du faisceau émis par la source 200 coïncidant avec l'axe défini par l'intersection du plan de symétrie 104 et du plan médian 106, et la lumière émise étant dirigée vers les structures à effet de prisme.

Ainsi, la lumière reçue directement en provenance de la source lumineuse 200 par les facettes de renvoi 158, 160 et 162, est renvoyée vers la face principale 103, perpendiculairement à celle-ci. La lumière ainsi renvoyée par les facettes de renvoi 158, 160, 162, traverse donc sans réfraction la face principale 103 et atteint l'aiguille.

De même, la lumière passant à l'extérieur des facettes de renvoi 158, 160, 162, est récupérée par les prismes en toit 130, 140, et tout d'abord transformée en faisceau parallèle et renvoyée perpendiculairement au plan de symétrie 104 par les prismes en toit 130, 140 précités, puis déviée vers la face principale 103, perpendiculairement à celle-ci par les facettes de renvoi 150, 152, 154 et 156. Cette partie de lumière traverse par conséquent sans réfraction la face principale 103 et atteint l'aiguille.

On comprendra ainsi que la structure du guide optique représenté sur les figures 1 à 6, permet de couvrir 360° autour de l'axe 121.

En d'autres termes cette structure permet d'éclairer l'aiguille quelle que soit la position angulaire de celle-ci autour de l'axe 121.

La présente invention permet par conséquent de réaliser le dispositif indicateur sous forme d'un sous-ensemble autonome, comprenant l'appareil indicateur, la source lumineuse 200 et le guide optique 100 et d'orienter ce sous-ensemble de façon quelconque par rapport au cadran associé à l'aiguille et à l'axe 121, selon l'encombrement imposé dans le tableau de bord, puisque l'aiguille associée sera toujours éclairée de façon homogène quelle que soit sa position angulaire autour de l'axe 121.

De préférence, la source lumineuse 200 est formée d'une diode électroluminescente dénommée couramment "LED".

Une telle diode électroluminescente 200 comprend essentiellement une puce 210 de matériau semi-conducteur, par exemple une jonction PN émettrice, deux connexions électriquement conductrices 212, 214 raccordées à la puce 210 et une optique 220.

Selon l'invention, l'optique 220 n'est pas symétrique de révolution autour de l'axe O-O.

De préférence, dans un premier plan passant par l'axe optique O-O, qui coïncide à l'utilisation avec le plan de symétrie 104, la surface externe de l'optique 220 a la forme d'une ellipse 221 comme représenté sur la figure 9. Un tel dioptre elliptique permet de générer le faisceau parallèle représenté sur la figure 14.

Par ailleurs, dans un second plan passant par l'axe optique O-O et orthogonal au plan précité, à savoir un plan qui coïncide à l'utilisation avec le plan médian 106 précité, la surface externe de l'optique 220 a la forme d'une calotte sphérique vue en coupe selon un arc de cercle 222 comme représenté sur la figure 8.

Un tel dioptre cylindrique permet de générer le faisceau divergent représenté sur la figure 13.

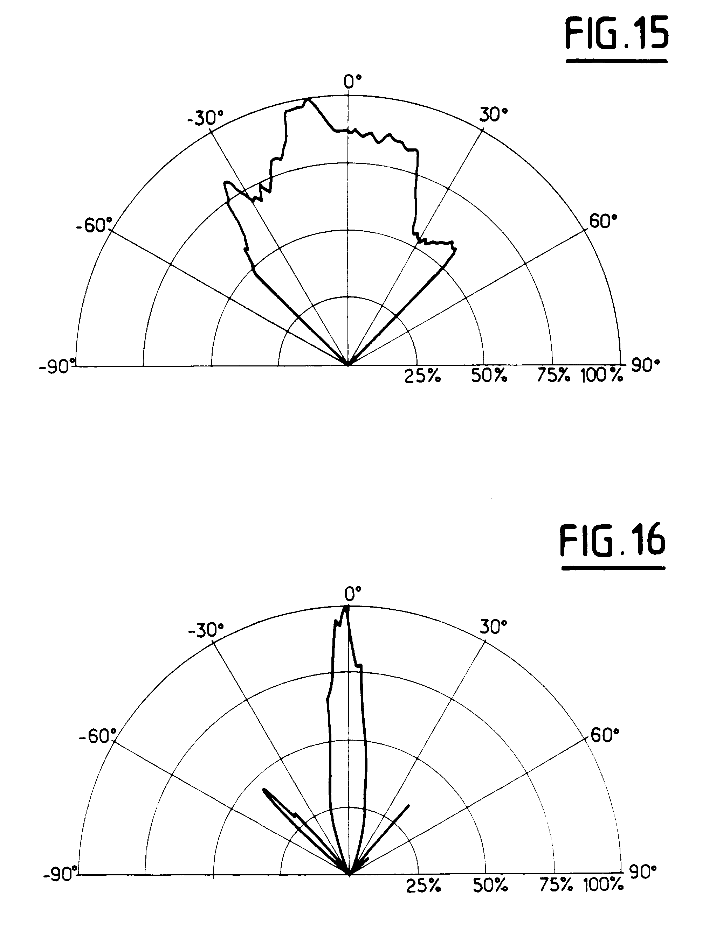

Plus précisément, on a représenté sur les figures 15 et 16, les distributions spatiales de l'intensité lumineuse mesurée dans deux plans orthogonaux entre eux coïncidant à l'utilisation respectivement avec le plan médian 106 et avec le plan de symétrie 104, d'une source lumineuse 200 conforme à la présente invention répondant aux données suivantes :

- rayon du cercle 222 dans le plan 106 : 4,2 mm,
- position de l'image de la puce 210 par rapport au sommet du dioptre sphérique 222 : 5,42 mm,
- équation de l'ellipse dans le plan 104 : $X^2/a^2 + Y^2/b^2 = 1$

$$a = 9.8$$
$$b = 5.1$$

- position du foyer de l'ellipse 221 par rapport au sommet du dioptre : 3,9 mm
- position de l'image de la puce 210 à travers le dioptre elliptique : INFINI (le faisceau sort parallèle).

L'homme de l'art comprendra qu'il est important de fixer avec précision la source lumineuse 200 par rapport au guide optique 100.

Le guide optique 100 doit en effet être centré sur le point source 105 de la source lumineuse 200.

Pour cela, on peut prévoir diverses dispositions.

Le guide optique 100 et la source lumineuse 200 peuvent être fixés sur un support commun.

Toutefois, de préférence, le guide optique 100 et la source lumineuse 200 forment une structure unitaire.

Pour cela, on peut prévoir de surmouler le guide optique 100 sur l'optique 220 de la source lumineuse 200.

On peut également surmouler le guide optique 100 directement sur la puce électroluminescente 210 en veillant à ménager lors de ce surmoulage le dioptre sphérique 222 et le dioptre elliptique 221 précédemment décrit.

MODE DE REALISATION PREFERENTIEL
(FIGURES 11 et 12)

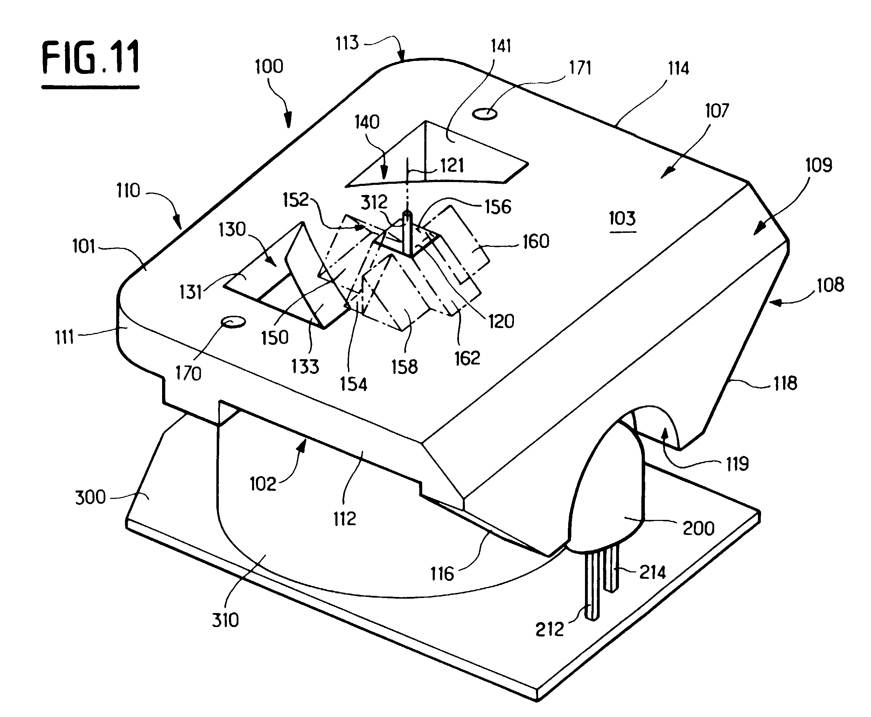

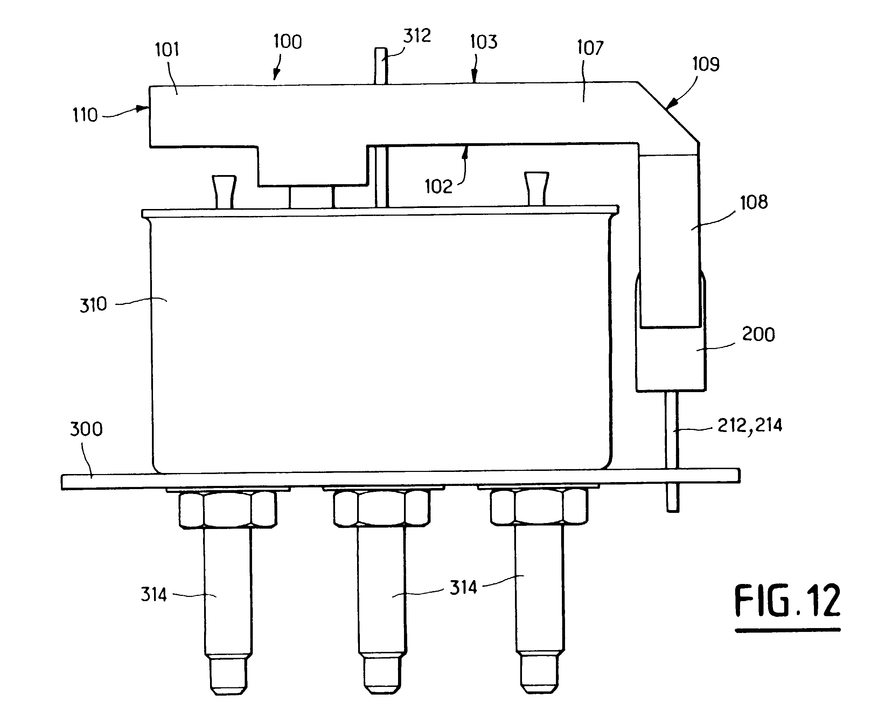

De préférence, comme représenté sur les figures 11 et 12 annexées, la plaquette 101 est repliée à 90° autour d'une ligne qui passe sensiblement par les arêtes 115, 117, communes aux faces latérales principales 116, 118, et aux faces latérales auxiliaires 112, 114. Ainsi, la plaquette 101 est formée essentiellement de deux parties 107, 108, orthogonales entre elles.

La partie 108 qui comprend la face latérale d'entrée 119 associée à la source lumineuse 200 fait saillie sur la face principale 102 de la partie 107.

La face principale 103 de la même partie 107 comprend une face tronquée 109. Cette face 109 est de préférence inclinée à 45° de la face 103. Sa ligne de plus grande pente est parallèle au plan de symétrie 104. La face de renvoi 109 s'étend sur toute la largeur de la partie 108 et en regard de celle-ci.

Le but de la face de renvoi 109 est de dévier de 90° la lumière provenant de la source lumineuse 200, pour renvoyer cette lumière parallèlement aux faces principales 102, 103, dans la partie 107 du guide optique.

On notera que le dispositif indicateur conforme à la présente invention, représenté sur les figures 11 et 12 constitue un ensemble autonome. Cet ensemble comprend une plaquette 300, par exemple une plaquette de circuit imprimé qui porte un appareil indicateur 310, tel qu'un logomètre.

L'arbre de commande rotatif, c'est-à-dire l'arbre de sortie de l'appareil indicateur 310 est référencé 312. Cet arbre 312 travers l'orifice 120 et est centré sur l'axe 121.

On rappelle que les logomètres 310 sont des appareils comprenant plusieurs bobines croisées, de préférence deux bobines croisées à 90°, un axe guidé à rotation, un aimant solidaire de l'axe placé dans la région du champ commun aux deux bobines, et des moyens de commande appliquant les signaux électriques appropriés aux bobines.

Le plus souvent les logomètres comprennent également une coupelle fixe comprenant un liquide d'amortissement dans lequel baigne l'aimant.

Chacune des bobines génère un champ magnétique proportionnel au courant qui la traverse. L'aimant se positionne selon la résultante de ces champs. Pour un logomètre à deux bobines, l'angle défini par l'aiguille indicatrice, par rapport à une position d'origine, est donc déterminée par la relation tangente$^{-1}$ I1/I2, dans laquelle I1 et I2 représente une valeur proportionnelle aux ampères tours circulant respectivement dans les bobines.

Dans le domaine automobile, les logomètres à grande déviation sont utilisés généralement pour visualiser une vitesse ou le nombre de tours de rotation du moteur.

Par ailleurs, l'ensemble représenté sur les figures 11 et 12 annexées comprend une pièce optique 100 du type décrit précédemment dans laquelle la partie 107 portant les prismes en toit 130, 140 et les facettes de renvoi 150, 152, 154, 156, 158, 160 et 162 s'étend parallèlement à la plaquette 300, tandis que la partie 108 qui comprend la facette cylindrique d'entrée 109 s'étend perpendiculairement à cette plaquette 300.

Le cas échéant, la plaquette 300 peut porter en outre des composants associés au logomètre 310.

Selon un mode de réalisation préférentiel mais non limitatif, la plaquette 100 représentée sur les figures 1 à 6 et 11 et 12, répond aux données suivantes :

- rayon de l'arête supérieure 134, 144 des prismes en toit : 100 mm,
- distance séparant le centre de cette arête supérieure 134, 144 du plan de symétrie 104 : 69,69 mm,
- rayon de la face cylindrique d'entrée 119 : 7,5 mm,
- épaisseur de la plaquette 101 : 4 mm,
- largeur des facettes de renvoi 150, 152, 158, 160, 162 : 4 mm,
- largeur des facettes de renvoi 154, 156 : 2 mm.

Selon le mode de réalisation représenté sur les figures 11 et 12, la plaquette 101 formant guide optique est fixée sur l'appareil indicateur 310 grâce aux orifices 170, 171 et aux pattes 172, 173 précitées.

Sur la figure 11, on a esquissé en traits interrompus, les facettes de renvoi 150, 152, 154, 156, 158, 160 et 162.

On notera que la source lumineuse 200 est fixée sur la plaquette 300, grâce à ses connexions 212, 214, selon le mode de réalisation représenté sur les figures 11 et 12.

Par ailleurs, on a référencé 314, sur la figure 12, les bornes de sortie de l'appareil indicateur 310.

VARIANTES DE REALISATION

Bien entendu, la présente invention peut faire l'objet de diverses variantes de réalisation.

Les facettes de renvoi 150, 152, 154, 156, 158, 160, 162 inclinées à 45° des faces principales 102, 103 permettent de renvoyer de la lumière vers la face principale 103 sur une zone de largeur égale à l'épaisseur de la plaquette 101.

Toutefois de préférence, la dimension de la surface de renvoi couverte par les facettes de renvoi 150, 152, 154, 156, 158, 160, 162 est supérieure à un disque de 10 mm de diamètre centré sur l'axe 121, la zone collectrice de lumière de l'aiguille ayant un rayon qui peut atteindre 5 mm, tandis que l'épaisseur de la plaquette 101 est inférieure ou égale à 3 ou 4 mm, pour des questions d'encombrement.

Pour concilier ces deux impératifs, l'invention propose une variante de réalisation des facettes 150, 152, 154, 156, 158, 160, 162 représentée sur la figure 18.

Selon cette variante de réalisation, les facettes de renvoi 150, 152, 154, 156, 160, 162 sont formées chacune d'une multitude de plans 180 inclinés à 45° des faces principales 102, 103 et espacés entre eux par des plans 181 parallèles aux faces principales 102, 103, et dont la longueur est proportionnelle à l'épaisseur locale de la plaquette 101.

Les plans inclinés 180 ont leur ligne de plus grande pente parallèle aux lignes de plus grande pente des facettes 150, 152, 154, 156, 160, 162 précitées.

La variante de réalisation représentée sur la figure 18, est conçue pour travailler avec une source lumineuse générant un faisceau parallèle dans le plan médian 106 et divergent dans le plan de symétrie 104. La divergence du faisceau utilisé est typiquement de plus ou moins 4°.

La forme du faisceau lumineux étant ainsi légèrement conique dans le plan de symétrie 104, les plans 180 réfléchissent la lumière avec la même ouverture, ce qui permet d'éclairer une surface plus ou moins grande suivant la hauteur.

Plus précisément, la longueur 1 de chaque plat 181 contenu entre deux plans inclinés 180 est définie par la relation :

L = 2h tangente A, dans laquelle :

h représente la hauteur locale de la plaquette 101, et

A représente l'ouverture du faisceau.

L'homme de l'art comprendra aisément qu'une telle disposition permet de couvrir une zone de renvoi de dimension nettement supérieure à l'épaisseur de la plaquette 101.

De préférence, les facettes de renvoi représentées sur la figure 18 sont utilisées en combinaison avec une source lumineuse non ponctuelle, par exemple un néon ou une source à incandescence.

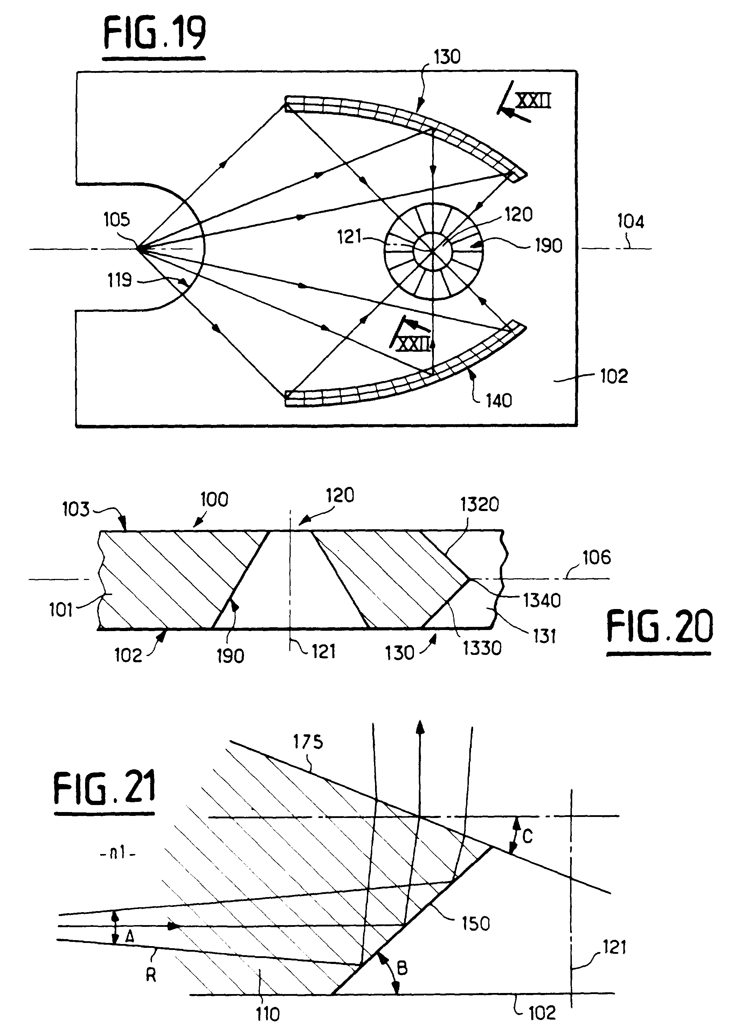

On a représenté sur les figures 19 et 20 une autre variante avantageuse de la présente invention selon laquelle les structures à prismes de renvoi comprennent deux prismes en toit 130, 140, associés à une surface conique 190.

Les deux prismes en toit 130, 140 sont symétriques par rapport au plan 104. Chaque prisme en toit est formé de deux faces 1320, 1330 symétriques par rapport au plan médian 106 parallèles aux faces principales 102, 103 et équi-distant de celles-ci. Les faces 1320, 1330, sont définies par des génératrices inclinées à 45° des faces principales 102, 103 et qui s'appuient sur une ellipse. Ainsi, l'arête supérieure 1340 du prisme en toit, à savoir l'intersection entre les faces 1320 et 1330 qui est contenue dans le plan médian 106 décrit une ellipse. L'un des foyers de cette ellipse correspond au point image 105 tandis que l'autre foyer de l'ellipse coïncide avec l'axe 121 de l'aiguille.

La surface conique 190 est centrée sur l'axe 121. Elle est définie par une génératrice inclinée à 45° des faces principales 102, 103. Cette surface de renvoi 190 converge vers la face principale 103.

En variante, la surface de renvoi 190 peut être formée par juxtaposition d'une multitude de facettes planes accolées.

Le guide optique 100 représenté sur les figures 19 et 20 est conçu pour être utilisé avec une source lumineuse qui génère un faisceau sensiblement parallèle considéré dans le plan de symétrie 104 et un faisceau divergent par exemple une ouverture de plus ou moins 45° dans le plan médian 106.

Le faisceau lumineux issu du point image 105 est renvoyé en direction de l'axe 121, dans une direction généralement parallèle aux faces principales 102, 103 de la plaquette 101, par les prismes en toit 130, 140.

La surface conique de renvoi 190 renvoie ensuite le faisceau lumineux en direction de l'aiguille, soit perpendiculairement à la face principale 103.

Bien entendu la présente invention n'est pas limitée aux modes de réalisation précédemment décrits mais s'étend à toute variante conforme à son esprit.

Le guide optique 100 peut être réalisé en tout matériau optiquement transparent connu de l'homme de l'art.

Il s'agit de préférence d'une matière plastique moulable, très préférentiellement du polycarbonate ou du polyméthylmétacrylate.

Le cas échéant, la source lumineuse 200 peut être formée d'une diode électroluminescente bicolore.

Un tel composant est connu en soi de l'homme de l'art. Dans le cadre de la présente invention, on peut utiliser le changement de couleur de la source lumineuse 200, donc de l'aiguille associée, pour un certain état du paramètre à visualiser, par exemple pour un régime moteur dépassant un seuil.

Dans le cadre de la description qui précède, on a indiqué que les diverses surfaces de renvoi sont inclinées à 45° des faces principales 102, 103.

Cette valeur particulière est retenue de préférence pour donner aux surfaces de renvoi des propriétés de réflexion totale. En effet, on sait que lorsque les rayons lumineux se propagent dans un milieu d'indice élevé, à savoir le matériau composant la plaquette 101 en l'espèce, si ces rayons rencontrent une surface d'indice faible, l'air, ils sont totalement réfléchis si l'angle d'incidence est supérieur à l'angle limite.

L'angle limite AL est donné par la formule: sinus AL = N1/N2, relation dans laquelle N1 et N2 représentent les indices respectivement faible du milieu situé au delà de l'interface et du haut milieu situé en deçà de celle-ci.

Pour le polycarbonate, l'indice est de 1,491, l'angle limite est donc de 42,12°.

L'homme de l'art comprendra de ce fait, que les faces de renvoi prévues sur la plaquette 101 peuvent présenter une inclinaison différente de 45° par rapport aux faces principales 102, 103, sous réserve que ces faces de renvoi présentent une inclinaison supérieure à l'angle limite.

En variante, on peut utiliser des facettes de renvoi 150, 152, 154, 156, 158, 160, 162 et 190 présentant une inclinaison plus faible sur les faces principales 102, 103, comme représenté sur la figure 21 sous réserve de prévoir au niveau de la face de sortie 103, des facettes obliques 175 travaillant par réfraction pour redresser les rayons lumineux parallèlement à l'axe 121.

Les facettes obliques 175 sont placées respectivement en regard des facettes de renvoi 150, 152, 154, 156, 158, 160, 162 et 190. Elles ont leur ligne de plus grande pente dans des plans perpendiculaires aux faces principales 102, 103 respectivement parallèles aux lignes de plus grande pente des facettes de renvoi associées 150, 152, 154, 156, 160, 162 et 190.

On démontre que si l'on appelle A l'angle d'ouverture du faisceau lumineux incident issu de la source lumineuse dans le plan 104, B l'inclinaison des facettes de renvoi 150, 152, 154, 156, 160, 162 et 190 sur la face principale 102, n1 l'indice du milieu composant la plaquette 101 et C l'inclinaison des facettes 175 travaillant par réfraction par rapport à la face principale 102, il faut $C = A + \text{arctg} [\sin A/(n1 - \cos A)]$ pour obtenir en sortie des facettes 175 un faisceau centré sur un axe parallèle à l'axe 121.

La formule ci-dessus est valable sous réserve que l'angle B soit choisi de sorte que le rayon incident R ayant le plus faible angle d'incidence ait une incidence par rapport aux facettes de renvoi 150 etc... supérieure à l'angle limite, de préférence supérieure à 45°.

On notera que les facettes 175 présente une pente de signe opposé de la pente des facettes de renvoi 150, 152, 154, 156, 160, 162 et 190 respectivement associées.

A titre d'exemple non limitatif, la facette de renvoi 150 illustrée sur la figure 21 est inclinée de 41° sur la face principale 102, et la facette oblique 175 est inclinée de 23,5° par rapport à la face principale 102, pour un milieu d'indice nl = 1,492.

L'utilisation de facettes de renvoi inclinées par rapport à la face principale 102 d'un angle B inférieur à 45° et associées à des facettes obliques 175 travaillant par réfraction permet d'augmenter le flux lumineux récupéré par les facettes de renvoi, puisqu'elle permet de réfléchir des rayons qui sous cette inclinaison faible des facettes de renvoi, auraient un angle d'incidence inférieur à l'angle limite.

La source lumineuse 200 n'est pas limitée aux diodes électroluminescentes. On peut par exemple utiliser un système type néon ou une source à incandescence.

Le guide optique 100 peut par ailleurs être formé d'une structure double de celle illustrée sur les figures annexées pour éclairer avec une seule et même source lumineuse deux aiguilles associées respectivement à deux appareils indicateurs placés de préférence diamétralement opposés par rapport au centre de la source.

L'aiguille n'a pas été représentée sur les figures annexées pour simplifier l'illustration.

Cette aiguille peut être formée de toute structure connue en soi, par exemple du document FR-A-2615992, DE-A-3435377 et DE-A-3425029.

Dans le cadre du mode de réalisation précédemment décrit, la face d'entrée 119 est cylindrique de révolution autour d'un axe parallèle à l'axe 121. Et cette face d'entrée 119 coopère avec un faisceau incident parallèle dans le plan 104 et divergent ayant pour origine le centre de la face d'entrée 119, dans le plan 106. Ainsi le faisceau n'est pas dévié par réfraction lors de la traversée de la face d'entrée 119.

En variante, toutefois, on peut prévoir d'adopter la face d'entrée 119 de sorte que celle-ci travaille par réfraction afin d'adapter le faisceau incident avant que celui-ci n'atteigne les prismes en toit 130, 140 et/ou les facettes de renvoi 150, 152, 154, 156, 158, 160, 162 ou 190.

Par exemple, on peut prévoir une face d'entrée 119 conique, par exemple circulaire, dans le plan 106 pour modifier la divergence du faisceau incident dans ce plan, comme représenté sur la figure 22.

De même, on peut prévoir de donner à la face d'entrée 119 une forme elliptique dans le plan 104 pour transformer un faisceau incident divergent en un faisceau parallèle.

Une telle face d'entrée remplace le dioptre de la source lumineuse représenté sur les figures 7 à 10 et permet donc d'utiliser une source lumineuse simplifiée générant un faisceau conique.

Les faces latérales 110, 112, 114, 116 et 118 de la pièce optique 101 peuvent elles-mêmes être formées de prismes en toit pour récupérer une partie de la lumière perdue sans cela et renvoyer celle-ci vers l'aiguille. De tels prismes en toit évitent les fuites de lumière sur l'extérieur de la pièce optique 101.

Comme indiqué précédemment, l'arbre de commande sur lequel est chassée l'aiguille peut ne pas être issu directement de l'appareil indicateur, mais être lié à cet appareil indicateur, par l'intermédiaire d'un train d'engrenages.

Le cas échéant, on peut prévoir d'utiliser une seule structure de renvoi du type représenté sur la figure 18, centrée sur l'axe 121.

Pour générer un faisceau parallèle à partir d'une source lumineuse produisant un faisceau conique on peut placer l'image de la source lumineuse au foyer d'un miroir parabolique.

Par ailleurs, selon la description qui précède, les facettes de renvoi 132, 133, 142, 143, 150, 152, 154, 156, 158, 160 et 162 sont planes. Cependant en variante on peut prévoir d'utiliser des facettes de renvoi de contour parabolique dans un plan orthogonal au plan 106 et dont le foyer coïncide avec l'image de la source lumineuse, de sorte que ces facettes de renvoi transforment un faisceau incident en faisceau parallèle. Selon encore une autre variante la face principale de sortie 103 de la pièce optique peut être adaptée pour transformer par réfraction, en faisceau parallèle, un faisceau incident conique.

**Revendications**

1. Dispositif indicateur à aiguille, en particulier pour véhicules automobiles, du type connu comprenant:

- un appareil indicateur (310),
- un arbre de commande rotatif (312) entrainé par l'appareil indicateur (310),
- une aiguille éclairante liée à l'arbre de commande (312),
- une source lumineuse (200) et
- un guide optique (100), optiquement transparent, placé en regard de la source lumineuse (200), lequel guide optique (100) possède:
- une structure réfléchissante (150, 152, 154, 156, 160, 162; 190) généralement centrée sur l'axe (121) de l'arbre de commande (312) et de l'aiguille, pour renvoyer vers l'aiguille une partie de la lumière provenant de la source lumineuse, et
- au moins une structure (130,140) conçue pour renvoyer vers la structure réfléchissante (150-162,190) centrée sur l'axe de l'arbre de commande, la lumière qu'elle reçoit en provenance de la source lumineuse.

caractérisé par le fait que :

- la structure de renvoi prévue sur le guide optique (100) placé sur l'arrière de l'aiguille comprend au moins une structure de prisme en toit (130, 140) conçue pour renvoyer vers la structure réfléchissante (150, 152, 154, 156, 160, 162; 190) généralement centrée sur l'axe (121) de l'arbre de commande, la lumière qu'elle reçoit en provenance de la source lumineuse (200) lequel prisme en toit comprend deux faces symétriques par rapport à un plan médian (106) parallèles aux faces principales du guide optique et équidistant de celles-ci, et
- la structure réfléchissante généralement centrée sur l'axe (121) de l'arbre de commande comprend différentes facettes réfléchissantes (150, 152, 154, 156, 158, 160, 162; 190) réparties autour de l'axe (121) de l'arbre de commande et qui ont des lignes de plus grande pente non parallèles.

2. Dispositif indicateur selon la revendication 1 caractérisé par le fait que le guide (100) comprend deux prismes en toit symétriques (130, 140) non colinéaires.

3. Dispositif selon l'une des revendications 1 ou 2 caractérisé par le fait que chaque structure de prisme en toit (130, 140) est adaptée pour renvoyer sous forme d'un faisceau parallèle (FP) le faisceau divergent (FC) reçu d'une source lumineuse (105, 200).

4. Dispositif indicateur selon l'une des revendications 1 à 3, caractérisé par le fait que l'arête supérieure (134, 144) du prisme en toit (130, 140) décrit un cercle.

5. Dispositif indicateur selon l'une des revendications 1 à 4, caractérisé par le fait que le guide optique (100) comprend plusieurs facettes (152, 154, 156, 158, 160, 162) conçues pour dévier un faisceau lumineux reçu du prisme en toit (130, 140) afin de renvoyer ce faisceau vers l'aiguille.

6. Dispositif indicateur selon l'une des revendications 1 à 5, caractérisé par le fait que le guide optique (100) comprend des facettes (158, 160, 162) conçues pour dévier le faisceau reçu directement de la source lumineuse (200) vers l'aiguille.

7. Dispositif indicateur selon l'une des revendications 1 à 6, caractérisé par le fait que le guide optique comprend deux paires de facettes (150, 152, 154, 156) conçues pour renvoyer, vers l'aiguille, le faisceau réfléchi par deux structures de prisme en toit (130, 140).

8. Dispositif indicateur selon l'une des revendications 1 ou 2, caractérisé par le fait que l'arête supérieure (1340) du prisme en toit décrit une ellipse.

9. Dispositif indicateur selon la revendication 8, caractérisé par le fait que l'un des foyers de l'ellipse coïncide avec le centre (105) de la source lumineuse (200), tandis que le second foyer de l'ellipse coïncide avec l'axe (121) de l'aiguille.

10. Dispositif indicateur selon l'une des revendications 8 ou 9, caractérisé par le fait que la surface réfléchissante (190) centrée sur l'axe (121) de l'arbre de commande est une surface conique autour de cet axe.

11. Dispositif indicateur selon l'une des revendications 1 à 10, caractérisé par le fait que la source lumineuse (200) est conçue pour générer un faisceau sensiblement parallèle dans un plan de symétrie (104) orthogonal aux faces principales (102, 103) du guide optique et un faisceau divergent dans un plan médian de la plaquette parallèle aux faces principales (102, 103) de celle-ci.

12. Dispositif indicateur selon l'une des revendications 1 à 10, caractérisé par le fait que la pièce optique (100) possède une face d'entrée (119) conçue pour générer à partir d'un faisceau conique issu d'une source lumineuse (105, 200), un faisceau sensiblement parallèle dans un plan de symétrie (104) orthogonal aux faces principales (102, 103) du guide optique et un faisceau divergent dans un plan médian de la plaquette parallèle aux faces principales (102, 103) de celle-ci.

**13.** Dispositif indicateur selon l'une des revendications 1 à 12, caractérisé par le fait que l'une au moins des facettes réfléchissantes réparties autour de l'axe (121) de l'arbre de commande comprend plusieurs facettes planes (180) inclinées sur les faces principales du guide optique et séparées par des facettes planes (181) parallèles aux faces principales du guide (100).

**14.** Dispositif indicateur selon la revendication 13, caractérisé par le fait que les facettes planes (181) parallèles aux faces principales (102, 103) du guide (100) ont des longueurs proportionnelles à la hauteur locale (h) du guide (100).

**15.** Dispositif indicateur selon l'une des revendications 13 ou 14, caractérisé par le fait que les facettes planes (181) parallèles aux faces principales (102, 103) du guide (100) ont des longueurs égales à 2h tangente A, relation dans laquelle :
h représente la hauteur locale du guide (100), et
A représente l'ouverture du faisceau généré par la source lumineuse (200) dans un plan de symétrie (104) orthogonal aux faces principales (102, 103) du guide.

**16.** Dispositif indicateur selon l'une des revendications 1 à 15, caractérisé par le fait que la source lumineuse est formée d'une diode électroluminescente (200).

**17.** Dispositif indicateur selon la revendication 16, caractérisé par le fait que la source lumineuse (200) est fixée sur le guide optique (100).

**18.** Dispositif indicateur selon la revendication 17, caractérisé par le fait que le guide optique (100) est surmoulé sur la source lumineuse (200).

**19.** Dispositif indicateur selon la revendication 17, caractérisé par le fait que le guide optique (100) est surmoulé sur une jonction semi-conductrice (210).

**20.** Dispositif indicateur selon l'une des revendications 1 à 19, caractérisé par le fait que la source lumineuse (200) comprend une optique (220) présentant des géométries différentes dans deux plans de symétrie perpendiculaires.

**21.** Dispositif indicateur selon la revendication 20, caractérisé par le fait que l'enveloppe de l'optique (220) décrit une ellipse dans un premier plan de symétrie et un cercle dans un plan de symétrie orthogonal.

**22.** Dispositif indicateur selon l'une des revendications 1 à 21, caractérisé par le fait que le guide est réalisé en polycarbonate ou en polyméthylemétacrylate.

**23.** Dispositif indicateur selon l'une des revendications 1 à 22, caractérisé par le fait que le guide (100) est réalisé sous forme d'une plaque plane (101).

**24.** Dispositif indicateur selon l'une des revendications 1 à 22, caractérisé par le fait que le guide (100) est réalisé sous forme de deux parties planes (107, 108) inclinées entre elles d'environ 90° et pourvues d'une face tronquée de renvoi (109) au niveau de la jonction entre ces deux parties (107, 108).

**25.** Dispositif indicateur selon l'une des revendications 1 à 24, caractérisé par le fait que le guide optique (100) comprend une face d'entrée cylindrique (119) centrée sur l'image de la source lumineuse (200) vue à travers son optique.

**26.** Dispositif indicateur selon la revendication 10, caractérisé par le fait que la surface réfléchissante (190) est formée de plusieurs facettes accolées s'appuyant sur une enveloppe conique.

**27.** Dispositif indicateur selon l'une des revendications 1 à 26, caractérisé par le fait que l'une au moins des facettes de renvoi (150, 152, 154, 156, 158, 160, 162) présente une inclinaison (B) par rapport aux faces principales (102, 103) de la pièce optique (101) inférieur à 45°, et que cette facette de renvoi est associée à une facette (175) travaillant par réfraction, elle-même oblique sur les faces principales (102, 103).

**28.** Dispositif indicateur selon la revendication 27, caractérisé par le fait que la facette (175) travaillant par réfraction est conçue pour redresser le faisceau émergeant de sorte que celui-ci soit généralement parallèle à l'axe (121) de l'arbre de commande.

**29.** Dispositif indicateur selon l'une des revendications 27 ou 28, caractérisé par le fait que la facette (175) travaillant par réfraction est inclinée d'un angle (C) tel que $C = A + \text{arctg}[\sin A/(n1 - \cos A)]$ par rapport aux faces principales (102, 103) de la pièce optique (101) relation dans laquelle :
A représente l'ouverture du faisceau incident,
B représente l'inclinaison de la facette de renvoi (150) sur les faces principales (102, 103) de la pièce optique , et
$n1$ représente l'indice du milieu formant la pièce optique.

**30.** Dispositif indicateur selon l'une des revendications 27 à 29, caractérisé par le fait que l'une au moins des facettes de renvoi (150, 152, 154, 156, 158, 160, 162) est inclinée d'environ 41° par rapport aux faces principales (102, 103) de la pièce optique (101) et que cette facette de renvoi est associée à une facette (175) travaillant par réfraction inclinée d'environ 23,5° par rapport aux faces principales (102, 103).

31. Dispositif indicateur selon l'une des revendications 1 à 30, caractérisé par le fait que les faces latérales (110, 112, 114, 116, 118) de la pièce optique (101) sont formées de prismes en toit.

32. Dispositif indicateur selon l'une des revendications 1 à 31, caractérisé par le fait que les faces réfléchissantes (132, 133, 142, 143, 150, 152, 154, 156, 158, 160, 162) sont planes.

33. Dispositif indicateur selon l'une des revendications 1 à 31, caractérisé par le fait que certaines au moins des faces réfléchissantes (132, 133, 142, 143, 150, 152, 154, 156, 158, 160, 162) sont de contour parabolique et ont leur foyer qui coïncide avec l'image de la source lumineuse.

## Patentansprüche

1. Anzeigevorrichtung mit einem Zeiger, insbesondere für Kraftfahrzeuge, einer bekannten Art, welche folgendes aufweist:

- ein Anzeigegerät (310),
- eine drehbare Betätigungswelle (312), welche von dem Anzeigegerät (310) angetrieben wird,
- einen an die Betätigungswelle (312) angeschlossenen beleuchteten Zeiger,
- eine Lichtquelle (200), und
- eine optisch durchlässige optische Führung (100), welche gegenüber der Lichtquelle (200) angeordnet ist, wobei diese optische Führung (100) folgendes aufweist:;
- eine reflektierende Struktur (150, 152, 154, 156, 160, 162; 190), welche allgemein auf die Achse (121) der Betätigungswelle (312) und des Zeigers zentriert ist, um einen Teil des von der Lichtquelle abgestrahlten Lichtes an den Zeiger zurückzuleiten, und
- mindestens eine Struktur (130, 140), welche so ausgelegt ist, daß sie an die auf die Achse der Betätigungswelle zentrierte reflektierende Struktur (150, 162, 190) das Licht zurückleiten kann, welches sie von der Lichtquelle empfängt,
  **dadurch gekennzeichnet, daß**
- die auf der optischen Führung (100) vorgesehene reflektierende Struktur, welche an der Rückseite des Zeigers angeordnet ist, mindestens ein dachförmiges Prisma (130, 140) aufweist, welches an die weitgehend auf der Achse (121) der Betätigungswelle zentrierte reflektierende Struktur (150, 152, 154, 156, 160, 162; 190) das Licht zurückleitet, welches sie von der Lichtquelle (200) empfängt, wobei dieses dachförmige Prisma zwei gegenüber einer Mittellinie (106) symmetrisch angeordnete Flächen aufweist, welche parallel zu den Hauptflächen der optischen Führung verlaufen und in gleichmäßigen Abständen dazu angeordnet sind, und
- dadurch, daß die weitgehend auf die Achse (121) der Betätigungswelle zentrierte reflektierende Struktur verschiedene reflektierende Facetten (150, 152, 154, 156, 158, 160, 162; 190) aufweist, welche um die Achse (121) der Betätigungswelle verteilt sind und deren am weitesten geneigte Linien nicht parallel verlaufen.

2. Anzeigevorrichtung nach Anspruch 1, **dadurch gekennzeichnet, daß** die optische Führung (100) zwei dachförmige symmetrische nicht kolineare Prismen (130, 140) aufweist.

3. Anzeigevorrichtung nach einem der Ansprüche 1 oder 2, **dadurch gekennzeichnet, daß** jedes der dachförmigen Prismen (130, 140) dafür ausgelegt ist, das von einer Lichtquelle (105, 200) empfangene divergierende Lichtbündel (FC) in Form eines parallelen Lichtbündels (FP) zurückzusenden.

4. Anzeigevorrichtung nach einem der Ansprüche 1 bis 3, **dadurch gekennzeichnet, daß** die Oberkante (134, 144) des dachförmigen Prismas (130, 140) einen Kreis bildet.

5. Anzeigevorrichtung nach einem der Ansprüche 1 bis 4, **dadurch gekennzeichnet, daß** die optische Führung (100) mehrere Facetten (152, 154, 156, 158, 160, 162) aufweist, welche dafür ausgelegt sind, ein von dem dachförmigen Prisma (130, 140) empfangenes Lichtbündel abzuleiten, um so dieses Lichtbündel an den Zeiger zurückzuleiten.

6. Anzeigevorrichtung nach einem der Ansprüche 1 bis 5, **dadurch gekennzeichnet, daß** die optische Führung (100) Facetten (158, 160, 162) aufweist, welche dafür ausgelegt sind, das direkt von der Lichtquelle (200) empfangene Lichtbündel an den Zeiger abzuleiten.

7. Anzeigevorrichtung nach einem der Ansprüche 1 bis 6, **dadurch gekennzeichnet, daß** die optische Führung zwei Paar Facetten (150, 152, 154, 156) aufweist, welche dafür ausgelegt sind, das von zwei dachförmigen Prismen (130, 140) reflektierte Lichtbündel an den Zeiger zurückzuleiten.

8. Anzeigevorrichtung nach einem der Ansprüche 1 oder 2,
   **dadurch gekennzeichnet, daß**
   die Oberkante (134) des Prismas eine Ellipse bildet.

9. Anzeigevorrichtung nach Anspruch 8,
   **dadurch gekennzeichnet, daß**
   einer der Brennpunkte der Ellipse mit dem Mittelpunkt (105) der Lichtquelle (200) zusammenfällt, während der zweite Brennpunkt der Ellipse mit der Achse (121) des Zeigers zusammenfällt.

10. Anzeigevorrichtung nach einem der Ansprüche 8 oder 9,
    **dadurch gekennzeichnet, daß**
    die auf die Achse (121) der Betätigungswelle zentrierte reflektierende Oberfläche eine um diese Achse verlaufende konische Fläche ist.

11. Anzeigevorrichtung nach einem der Ansprüche 1 bis 10,
    **dadurch gekennzeichnet, daß**
    die Lichtquelle (200) so ausgelegt ist, daß sie ein weitgehend paralleles Lichtbündel in einer Symmetrieebene (104) erzeugen kann, welche rechtwinklig zu den Hauptflächen (102, 103) der optischen Führung verläuft, sowie ein divergierendes Lichtbündel in einer mittleren Ebene der zu deren Hauptflächen (102, 103) parallel verlaufenden Facette.

12. Anzeigevorrichtung nach einem der Ansprüche 1 bis 10,
    **dadurch gekennzeichnet, daß**
    die optische Führung (100) eine Eintrittsfläche (119) besitzt, welche dafür ausgelegt ist, aus einem von einer Lichtquelle (105, 200) abgestrahlten konischen Lichtbündel ein weitgehend paralleles Lichtbündel in einer Symmetrieebene (104) zu erzeugen, welche rechtwinklig zu den Hauptflächen (102, 103) der optischen Führung verläuft, sowie ein divergierendes Lichtbündel in einer mittleren Ebene der zu deren Hauptflächen (102, 102) parallel verlaufenden Facette zu erzeugen.

13. Anzeigevorrichtung nach einem der Ansprüche 1 bis 12,
    **dadurch gekennzeichnet, daß**
    mindestens eine der um die Achse (121) der Betätigungswelle verteilten reflektierenden Facetten mehrere ebene Facetten (180) aufweist, welche gegenüber den Hauptflächen der optischen Führung geneigt sind und mit Hilfe von ebenen Facetten (181) getrennt sind, welche parallel zu den Hauptflächen der optischen Führung (100) verlaufen.

14. Anzeigevorrichtung nach Anspruch 13,
    **dadurch gekennzeichnet, daß**
    die parallel zu den Hauptflächen (102, 103) der optischen Führung (100) verlaufenden ebenen Facetten (181) ein Länge haben, welche proportional zu der lokalen Höhe (h) der optischen Führung (100) ist.

15. Anzeigevorrichtung nach einem der Ansprüche 13 oder 14,
    **dadurch gekennzeichnet, daß**
    die parallel zu den Hauptflächen (102, 103) der optischen Führung (100) verlaufenden ebenen Facetten (181) eine Länge haben, welche gleich 2h der Tangente A ist; in dieser Gleichung ist:
    h die lokale Höhe der optischen Führung (100), A die Weite des von der Lichtquelle (200) erzeugten Lichtbündels in einer Symmetrieebene (104), welche rechtwinklig zu den Hauptflächen (102, 103) der optischen Führung (100) verläuft.

16. Anzeigevorrichtung nach einem der Ansprüche 1 bis 15,
    **dadurch gekennzeichnet, daß**
    die Lichtquelle aus einer Elektroluminszensdiode (200) besteht.

17. Anzeigevorrichtung nach Anspruch 16,
    **dadurch gekennzeichnet, daß**
    die Lichtquelle (200) an der optischen Führung (100) befestigt ist.

18. Anzeigevorrichtung nach Anspruch 17,
    **dadurch gekennzeichnet, daß**
    die optische Führung (100) auf die Lichtquelle (200) aufgeschweißt ist.

19. Anzeigevorrichtung nach Anspruch 17,
    **dadurch gekennzeichnet, daß**
    die optische Führung (100) auf eine Halbleiterverbindung (210) aufgeschweißt ist.

20. Anzeigevorrichtung nach einem der Ansprüche 1 bis 19,
    **dadurch gekennzeichnet, daß**
    die Lichtquelle (200) eine Optik (220) aufweist, welche in zwei rechtwinkligen Symmetrieebenen verschiedene Geometrien aufweist.

21. Anzeigevorrichtung nach Anspruch 20,
    **dadurch gekennzeichnet, daß**
    die Umhüllende der Optik (220) in einer ersten Symmetrieebene eine Ellipse und in einer dazu rechtwinkligen Symmetrieebene einen Kreis bildet.

22. Anzeigevorrichtung nach einem der Ansprüche 1 bis 21,
**dadurch gekennzeichnet, daß**
die optische Führung aus einem Polykarbonat oder einem Polymethylmethacrylat hergestellt ist.

23. Anzeigevorrichtung nach einem der Ansprüche 1 bis 22,
**dadurch gekennzeichnet, daß**
die optische Führung (100) die Form einer ebenen Platte (101) hat.

24. Anzeigevorrichtung nach einem der Ansprüche 1 bis 22,
**dadurch gekennzeichnet, daß**
die optische Führung (100) aus zwei ebenen Teilen (107, 108) besteht, welche zueinander um 90° geneigt und an der Verbindung zwischen diesen beiden Teilen (107, 108) mit einer stumpfen Umlenkfläche (109) ausgestattet sind.

25. Anzeigevorrichtung nach einem der Ansprüche 1 bis 24,
**dadurch gekennzeichnet, daß**
die optische Führung (100) eine zylindrische Eintrittsfläche (119) aufweist, welche auf das durch ihre Optik gesehene Bild der Lichtquelle (200) zentriert ist.

26. Anzeigevorrichtung nach Anspruch 10,
**dadurch gekennzeichnet, daß**
die reflektierende Fläche (190) aus mehreren aneinanderliegenden Facetten besteht, welche sich an einer konischen Umhüllenden abstützen.

27. Anzeigevorrichtung nach einem der Ansprüche 1 bis 26,
**dadurch gekennzeichnet, daß**
mindestens eine der Umlenkfacetten (150, 152, 154, 156, 158, 160, 162) eine Neigung (B) gegenüber den Hauptflächen (102, 103) der optischen Führung (100) aufweist, welche kleiner als 34° ist, und dadurch, daß diese Umlenkfläche einer Facette (175) zugeordnet ist, welche durch Refraktion arbeitet und ihrerseits schräg gegenüber den Hauptflächen (102, 103) angeordnet ist.

28. Anzeigevorrichtung nach Anspruch 27,
**dadurch gekennzeichnet, daß**
die durch Refraktion arbeitende Facette so ausgelegt ist, daß sie das austretende Lichtbündel so richten kann, daß letzteres weitgehend parallel zur Achse (121) der Betätigungswelle verläuft.

29. Anzeigevorrichtung nach einem der Ansprüche 27 oder 28,

**dadurch gekennzeichnet, daß**
die durch Refraktion arbeitende Facette (175) um einen Winkel (C), wie zum Beispiel einem Winkel C = A-arctg [sinA/(n1 - cosA] gegenüber den Hauptflächen (102, 103) des optischen Teils (101) geneigt ist; in dieser Gleichung ist:
A die Weite des einfallenden Lichtbündels,
B die Neigung der Umlenkfacette (150) gegenüber den Hauptflächen (102, 103) des optischen Teils, und
n1 ist der Index des Mediums, aus dem das optische Teil hergestellt ist.

30. Anzeigevorrichtung nach einem der Ansprüche 27 bis 29,
**dadurch gekennzeichnet, daß**
mindestens eine der Umlenkfacetten (150, 152, 154, 156, 158, 160, 162) um etwa 41° gegenüber den Hauptflächen (102, 103) des optischen Teils (101) geneigt ist, und dadurch, daß diese Umlenkfacette einer durch Refraktion arbeitenden Facette (175) zugeordnet ist, welche um etwa 23,5° gegenüber den Hauptflächen (102, 103) geneigt ist.

31. Anzeigevorrichtung nach einem der Ansprüche 1 bis 30,
**dadurch gekennzeichnet, daß**
die Seitenflächen (110, 112, 114, 116, 118) des optischen Teils (101) aus dachförmigen Prismen bestehen.

32. Anzeigevorrichtung nach einem der Ansprüche 1 bis 31,
**dadurch gekennzeichnet, daß**
die Reflexionsflächen (132, 133, 142, 143, 150, 152, 154, 156, 158, 160, 162) eben sind.

33. Anzeigevorrichtung nach einem der Ansprüche 1 bis 31,
**dadurch gekennzeichnet, daß**
mindestens einige der Reflexionsflächen (132, 133, 142, 142, 150, 152, 154, 156, 160, 162) ein parabolisches Profil hat und dadurch, daß ihr Brennpunkt mit dem Bild der Lichtquelle zusammenfällt.

**Claims**

1. Indicator apparatus having a pointer, in particular for motor vehicles and of known type comprising:

   an indicator instrument (310);
   a rotary control shaft (312) driven by the indicator instrument (310);
   an illuminating pointer connected to the control shaft (312);
   a light source (200); and
   an optically transparent light guide (100) placed facing the light source (200), which light guide (100) possesses:

a reflecting structure (150, 152, 154, 156, 160, 162; 190) generally centered on the axis (121) of the control shaft (312) and of the pointer, to reflect a portion of the light coming from the light source towards the pointer; and

at least one directing structure (130, 140) designed to direct the light it receives from the light source towards the reflecting structure (150-162, 190) which is centered on the axis of the control shaft;

the apparatus being characterized by the fact that:

the directing structure provided on the light guide (100) placed behind the pointer includes at least one roof-shaped prism structure (130, 140) designed to direct the light it receives from the light source (200) towards the reflecting structure (150, 152, 154, 156, 160, 162; 190) which is generally centered on the axis (121) of the control shaft, which roof-shaped prism comprises two faces that are symmetrical about a midplane (106) parallel to the main faces of the light guide and equidistant therefrom; and

the reflecting structure which is generally centered on the axis (121) of the control shaft includes different reflecting facets (150, 152, 154, 156, 158, 160, 162; 190) distributed around the axis (121) of the control shaft and having lines of greatest slope that are not parallel.

2. Indicator apparatus according to claim 1, characterized by the fact that the guide (100) comprises two symmetrical roof-shaped prisms (130, 140) that are not collinear.

3. Apparatus according to claim 1 or 2, characterized by the fact that each roof-shaped prism structure (130, 140) is adapted to re-direct in the form of a parallel beam (FP) the light it receives from a light source (105, 200) in the form of a diverging beam (FC).

4. Indicator apparatus according to any one of claims 1 to 3, characterized by the fact that the top edge (134, 144) of the roof-shaped prism (130, 140) describes a circle.

5. Indicator apparatus according to any one of claims 1 to 4, characterized by the fact that the light guide (100) includes a plurality of facets (152, 154, 156, 158, 160, 162) designed to deflect a light beam received from the roof-shaped prism (130, 140) in order to direct said beam towards the pointer.

6. Indicator apparatus according to any one of claims 1 to 5, characterized by the fact that the light guide (100) includes facets (158, 160, 162) designed to deflect the beam received directly from the light source (200) towards the pointer.

7. Indicator apparatus according to any one of claims 1 to 6, characterized by the fact that the light guide includes two pairs of facets (150, 152, 154, 156) designed to direct towards the needle the beam reflected by the two roof-shaped prism structures (130, 140).

8. Indicator apparatus according to claim 1 or 2, characterized by the fact that the top edge (1340) of the roof-shaped prism describes an ellipse.

9. Indicator apparatus according to claim 8, characterized by the fact that one of the focuses of the ellipse coincides with the center (105) of the light source (200), while the second focus of the ellipse coincides with the axis (121) of the pointer.

10. Indicator apparatus according to claim 8 or 9, characterized by the fact that the reflecting surface (190) centered on the axis (121) of the control shaft is a conical surface about said axis.

11. Indicator apparatus according to any one of claims 1 to 10, characterized by the fact that the light source (200) is designed to generate a beam that is both substantially parallel in a plane of symmetry (104) orthogonal to the main faces (102, 103) of the light guide, and that is divergent in a midplane of the plate parallel to the main faces (102, 103) thereof.

12. Indicator apparatus according to any one of claims 1 to 10, characterized by the fact that the optical part (100) possesses an inlet face (119) designed to receive a conical beam from a light source (105, 200) and to generate therefrom a beam that is both substantially parallel in a plane of symmetry (104) orthogonal to the two main faces (102, 103) of the light guide, and that is divergent in a midplane of the plate parallel to the main faces (102, 103) thereof.

13. Indicator apparatus according to any one of claims 1 to 12, characterized by the fact that at least one of the reflecting facets distributed around the axis (121) of the control shaft comprises a plurality of plane facets (180) inclined relative to the main faces of the light guide and separated by plane facets (181) parallel to the main faces of the guide (100).

14. Indicator apparatus according to claim 13, characterized by the fact that the plane facets (181) parallel to the main faces (102, 103) of the guide (100) are of lengths that are proportional to the local height (h) of the guide (100).

**15.** Indicator apparatus according to claim 13 or 14, characterized by the fact that the plane facets (181) parallel to the main faces (102, 103) of the guide (100) are of lengths equal to 2h.tan(A) where:

h represents the local height of the guide (100); and

A represents the aperture of the beam generated by the light source (200) in a plane of symmetry (104) orthogonal to the main faces (102, 103) of the guide.

**16.** Indicator apparatus according to any one of claims 1 to 15, characterized by the fact that the light source is formed by a light-emitting diode (200).

**17.** Indicator apparatus according to claim 16, characterized by the fact that the light source (200) is fixed on the light guide (100).

**18.** Indicator apparatus according to claim 17, characterized by the fact that the light guide (100) is molded over the light source (200).

**19.** Indicator apparatus according to claim 17, characterized by the fact that the light guide (100) is molded over a semiconductor junction (210).

**20.** Indicator apparatus according to any one of claims 1 to 19, characterized by the fact that the light source (200) includes an optical system (220) having shapes that are different in two perpendicular planes of symmetry.

**21.** Indicator apparatus according to claim 20, characterized by the fact that the light envelope (220) describes an ellipse in a first plane of symmetry and a circle in an orthogonal plane of symmetry.

**22.** Indicator apparatus according to any one of claims 1 to 21, characterized by the fact that the guide is made of polycarbonate or of polymethyl methacrylate.

**23.** Indicator apparatus according to any one of claims 1 to 22, characterized by the fact that the guide (100) is made in the form of a plane plate (101).

**24.** Indicator apparatus according to any one of claims 1 to 22, characterized by the fact that the guide (100) is made in the form of two plane portions (107, 108) that are inclined to each other at about 90° and that are provided with a truncated reflecting face (109) at the junction between said two portions (107, 108).

**25.** Indicator apparatus according to any one of claims 1 to 24, characterized by the fact that the light guide (100) includes a cylindrical inlet face (119) centered on the image of the light source (200) as seen through its optical system.

**26.** Indicator apparatus according to claim 10, characterize by the fact that the reflecting surface (190) is made up of a plurality of adjacent facets bearing against a conical envelope.

**27.** Indicator apparatus according to any one of claims 1 to 26, characterized by the fact that at least one of the reflecting facets (150, 152, 154, 156, 158, 160, 162) is at an inclination (B) relative to the main faces (102, 103) of the optical part (101) of less than 45°, and that said reflecting facet is associated with a facet (175) that works by refraction, and itself oblique relative to the main faces (102, 103).

**28.** Indicator apparatus according to claim 27, characterized by the fact that the facet (175) working by refraction is designed to deflect the outgoing beam so that it is generally parallel to the axis (121) of the control shaft.

**29.** Indicator apparatus according to claim 27 or 28, characterized by the fact that the facet (175) working by refraction is inclined at an angle (C) such that $C = A + \arctan[\sin A/(n1 - \cos A)]$ relative to the main faces (102, 103) of the optical part (101), where:

A represents the aperture of the incident beam;
B represents the inclination of the reflecting facet (150) relative to the main faces (102, 103) of the optical part; and
n1 represents the refractive index of the medium constituting the optical part.

**30.** Indicator apparatus according to any one of claims 27 to 29, characterized by the fact that at least one of the reflecting facets (150, 152, 154, 156, 158, 160, 162) is inclined at about 41° relative to the main faces (102, 103) of the optical part (101) and that said reflecting facet is associated with a facet (175) working by refraction and inclined at about 23.5° relative to the main faces (102, 103).

**31.** Indicator apparatus according to any one of claims 1 to 30, characterized by the fact that the lateral faces (110, 112, 114, 115, 118) of the optical part (101) are formed by roof-shaped prisms.

**32.** Indicator apparatus according to any one of claims 1 to 31, characterized by the fact that the reflecting faces (132, 133, 142, 143, 150, 152, 154, 156, 158, 160, 162) are plane.

**33.** Indicator apparatus according to any one of claims 1 to 31, characterized by the fact that at least some of the reflecting faces (132, 133, 142, 143, 150, 152, 154, 156, 158, 160, 162) are parabolic in outline having their focuses coinciding with the image of the light source.

FIG.1

FIG.2

18

FIG.3

FIG.4

FIG.5

FIG.6

# FIG.7

# FIG.8

# FIG.9

# FIG.10

FIG.11

FIG.12

EP 0 551 222 B1

FIG.13

FIG.14

## FIG.15

## FIG.16

FIG.17

FIG.18

FIG.22

## FIG.19

## FIG.20

## FIG.21